# EUROPÄISCHE PATENTANMELDUNG

(11) **EP 2 101 352 A2**
(43) Veröffentlichungstag der Anmeldung: **16.09.2009**
(21) Anmeldenummer: 09002485.2
(22) Anmeldetag: 21.02.2009
(51) Int. Cl.: H01L 25/07

(54) **Leistungshalbleitermodul in Druckkontaktausführung**

(30) Priorität: 13.03.2008 DE 102008014113
(71) Anmelder: SEMIKRON Elektronik GmbH & Co. KG, 90431 Nürnberg (DE)
(72) Erfinder: Arnold, Reiner, 90559 Burgthann (DE); Popp, Rainer, 91580 Petersaurach (DE)

(57) **Zusammenfassung**

Leistungshalbleitermodul in Druckkontaktausführung mit einem Gehäuse, mit einem Kühlkörper, mit einem Substrat, mit darauf angeordneten Leistungshalbleiterbauelementen und ihnen zugeordeneten Lastanschlusselementen, wobei deren zum Substrat reichenden Kontaktelemente zur schaltungsgerechten Kontaktierung mit den Leistungshalbleiterbauelementen erfindungsgemäß ausgestaltet sind, um einen im Wesentlichen unterbrechungsfreien Stromfluss zu gewährleisten.

## Beschreibung

Die Erfindung beschreibt ein gehaustes Leistungshalbleitermodul in Druckkontaktausführung mit Last- und Hilfsanschlusselementen zur Anordnung auf einem Kühlbauteil.

Einen Ausgangspunkt der Erfindung bilden Leistungshalbleitermodule wie sie beispielhaft aus der DE 197 19 703 A1 bekannt sind. Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind Druck kontaktierte Leistungshalbleitermodule, wie sie aus der DE 42 37 632 A1, der DE 199 03 875 A1 oder der DE 101 27 947 C1 bekannt sind. Bei erstgenannter Druckschrift weist die Druckeinrichtung ein stabiles Druckelement zum Druckaufbau, ein elastisches Kissenelement zur Druckspeicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgeht.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Aus der DE 101 57 947 C1 ist ein Leistungshalbleitermodul bekannt, wobei die Lastanschlusselemente derart ausgebildet sind, dass sie in Abschnitten eng benachbart senkrecht zur Substratoberfläche verlaufen und von dort ausgehende Kontaktelemente aufweisen, die den elektrischen Kontakt zu den Leiterbahnen herstellen und gleichzeitig Druck auf das Substrat ausüben und somit dessen thermischen Kontakt zu einem Kühlbauteil herstellen. Der Druck wird hierbei mit Mitteln nach dem Stand der Technik eingeleitet und gespeichert.

Aus der DE 10 2006 006 423 A1 ist schließlich ein Leistungshalbleitermodul und ein zugehöriges Herstellungsverfahren bekannt, wobei die Lastanschlusselemente als Metallformkörper mit einem ersten Kontaktelement und einem bandartigen, parallel zur Substratoberfläche verlaufenden Abschnitt ausgeformt sind, von welchem innere Kontaktelemente die Kontaktierung mit dem Substrat ermöglichen. In derartigen Lastanschlusselementen wird der Strom regelmäßig über das erste Kontaktelement eingeleitet und in Längsrichtung des bandartigen Abschnitts und durch die zweiten Kontaktelemente geführt, welche hierdurch die entsprechend zugeordneten Leiterbahnen schaltungsgerecht kontaktieren, sodass sich regelmäßig in solchen Lastanschlusselementen ein Stromfluss in Längsrichtung ergibt, wobei je nach Anordnung der Kontaktelemente graduelle Abweichungen der Stromflussrichtung von der Längsrichtung von maximal 15° auftreten.

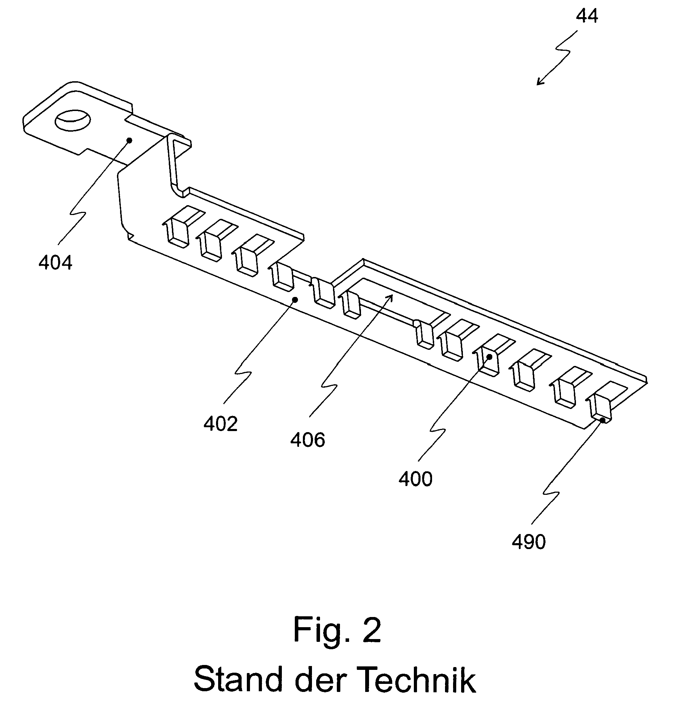

Nachteilig an den Leistungshalbleitermodulen nach dem bisher genannten Stand der Technik ist, dass die von den Lastanschlusselementen ausgehenden Kontaktelemente durch ein Stanz-Biege-Verfahren einstückig aus dem Material des Lastanschlusselements ausgestaltet werden. Dadurch werden das Materialvolumen und damit einhergehend die Stromtragefähigkeit des Lastanschlusselements vermindert. Diese Verminderung der Stromtragefähigkeit wird insbesondere dann erheblich, wenn der Stanz- und Biegevorgang zur Anordnung der Kontaktelemente den mittleren Flächenbereich des Lastanschlusselements betrifft (siehe den Stand der Technik in Figur 2) und das Materialvolumen des Lastanschlusselementes kontinuierlich in Querrichtung zur definierten Stromflussrichtung unterbricht. Derartige Unterbrechungen bewirken eine Verminderung der Stromtragefähigkeit des Lastanschlusselements und damit eine Verminderung der Leistungsfähigkeit des Leistungshalbleitermoduls.

Der Erfindung liegt die Aufgabe zugrunde ein Leistungshalbleitermodul in Druckkontaktausführung mit Lastanschlusselementen und ihnen zugeordneten Kontaktelementen zum Substrat vorzustellen, wobei die Stromtragefähigkeit mindestens eines Lastanschlusselements verbessert wird und die Ausbildung der Kontaktelemente einer einfachen und kostengünstigen Herstellung zugänglich ist.

Die Aufgabe wird erfindungsgemäß gelöst durch die Maßnahmen der Merkmale des Anspruchs 1. Bevorzugte Ausführungsformen sind in den Unteransprüchen beschrieben.

Der erfinderische Gedanke geht aus von einer Anordnung eines Leistungshalbleitermoduls in Druckkontaktausführung auf einem Kühlbauteil mit mindestens einem Substrat, mindestens zwei hierauf angeordneten Leistungshalbleiterbauelementen, beispielhaft Leistungstransistoren, einem Gehäuse und nach außen führenden Last- und Steueranschlusselementen. Das Substrat selbst weist einen Grundkörper und auf dessen erster, dem Inneren des Leistungshalbleitermoduls zugewandten Hauptfläche Leiterbahnen mit Lastpotential auf. Weiterhin weist das Substrat vorzugsweise auch mindestens eine Leiterbahn mit Steuerpotential zu Ansteuerung der Leistungshalbleiterbauelemente auf.

Das Leistungshalbleitermodul weist weiterhin Lastanschlusselemente jeweils ausgebildet als Metallformkörper mit einem ersten Kontaktelement, einem bandartigen Abschnitt und mit einer Mehrzahl von diesem ausgehenden zweiten Kontaktelementen auf. Die jeweiligen bandartige Abschnitte sind parallel zur Substratoberfläche und von dieser beabstandet angeordnet. Die zweiten Kontaktelemente, die von dem bandartigen Abschnitt ausgehen reichen zum Substrat und bilden dort schaltungsgerecht die Kontaktierung der Lastanschlüsse aus. Vorzugsweise kontaktieren sie hierzu auf dem Substrat die Leiterbahnen mit Lastpotential, alternativ auch direkt die Leistungshalbleiterbauelemente.

Erfindungsgemäß ist hierbei mindestens ein Lastanschlusselement derart ausgestaltet, dass die Kontaktelemente in Richtung des Substrates als einstückige, vorzugsweise noppenartige Vorsprünge ohne Materialunterbrechung des Lastanschlusses oder als freigestellte Kontaktnasen ohne Materialunterbrechung in Stromflussrichtung ausgestaltet sind. Hierbei ist von Vorteil, dass durch die in Längsrichtung des Stromflusses unterbrechungsfreie Ausgestaltung der Kontaktelemente die Stromtragefähigkeit des Lastanschlusselements nicht nachteilig verringert wird und somit die gesamte Leistungsfähigkeit des Leistungshalbleitermoduls gegenüber dem Stand der Technik erhöht wird. Weiterhin ist von Vorteil, dass die Vorsprünge durch ihre vorzugsweise konvexe Form und die Kontaktnasen durch ihre gewölbte Überspannung größere Kontaktflächen zu den Leiterbahnen des Substrats und somit in Verbindung mit der Druckeinrichtung größere Toleranzen hinsichtlich der sicheren Kontaktierung aufweisen. Somit ist die die Fertigung der erfindungsgemäßen Kontaktelemente einer einfachen und kostengünstigen Herstellung zugänglich.

Bevorzugt bilden weiterhin die Lastanschlusselemente einen Stapel, wobei hierbei zwischen jeweils benachbarten Lastanschlusselementen im Bereich der jeweiligen bandartigen Abschnitte eine isolierende Zwischenlage angeordnet ist.

Die erfinderische Lösung wird an Hand der Ausführungsbeispiele der Fig. 1 bis 7 weiter erläutert.

Fig. 1 zeigt im Querschnitt ein Leistungshalbleitermodul gemäß dem Stand der Technik.

Fig. 2 zeigt in dreidimensionaler Darstellung ein Lastanschlusselement gemäß dem Stand der Technik.

Fig. 3 zeigt im Querschnitt ein erfindungsgemäßes Leistungshalbleitermodul.

Fig. 4 zeigt in dreidimensionaler Ansicht eine erste Ausgestaltung eines Lastanschlusselements in einem erfindungsgemäßen Leistungshalbleitermodul in Auf (4a)- und Untersicht (4b).

Fig. 5 zeigt in dreidimensionaler Ansicht eine zweite Ausgestaltung eines Lastanschlusselements in einem erfindungsgemäßen Leistungshalbleitermodul in Auf (5a)- und Untersicht (5b).

Fig. 6 zeigt in dreidimensionaler Ansicht eine dritte Ausgestaltung eines Lastanschlusselements in einem erfindungsgemäßen Leistungshalbleitermodul in Auf (6a)- und Untersicht (6b).

Fig. 7a, b, und c zeigen einen zweidimensionalen Schnitt durch ein Lastanschlusselement gemäß den Fig. 4, 5 und 6 durch die Schnittebene A-A.

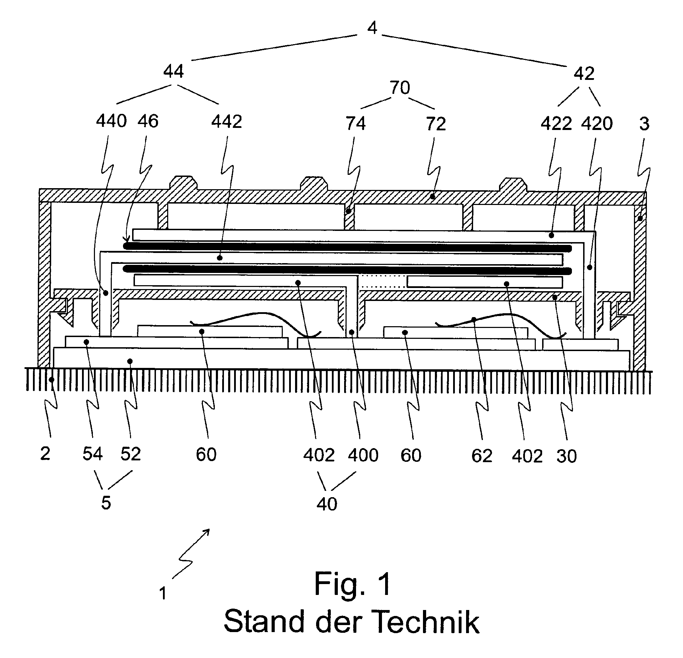

Fig. 1 zeigt einen Schnitt durch ein Leistungshalbleitermodul (1) gemäß dem Stand der Technik. Dieses weist ein Gehäuse (3) mit einem rahmenartigen Gehäuseteil auf, der fest mit dem Kühlbauteil (2) der Anordnung verbunden ist. Der rahmenartige Gehäuseteil umschließt hierbei das mindestens eine Substrat (5). Dieses wiederum weist einen Grundkörper (52), vorzugsweise eine Isolierkeramik wie Aluminiumoxid oder Aluminiumnitrit auf. Auf der dem Inneren des Leistungshalbleitermoduls (1) zugewandten ersten Hauptfläche weist das Substrat in sich strukturierte Leiterbahnen (54) auf. Auf den Leiterbahnen (54) des Substrats sind Leistungshalbleiterbauelemente (60) angeordnet und schaltungsgerecht mit weiteren Leiterbahnen (54), beispielhaft mittels Drahtbondverbindungen (62), verbunden.

Die Lastanschlusselemente (40, 42, 44) mit den verschiedenen notwendigen Potentialen dienen der externen Verbindung der leistungselektronischen Schaltung im Inneren des Leistungshalbleitermoduls (1). Hierzu sind die Lastanschlusselemente (40, 42, 44) als Metallformkörper ausgebildet, die je einen bandartigen Abschnitt (402, 422, 442) parallel zur Substratoberfläche aufweisen. Die bandartigen Abschnitte (402, 422, 442) bilden hierbei einen Stapel (4), wobei die bandartigen Abschnitte der einzelnen Lastanschlusselemente (40, 42, 44) jeweils mittels einer isolierenden Zwischenlage (46) voneinander beabstandet und somit gegeneinander elektrisch isoliert sind. Notwendige Hilfsanschlusselemente sind aus Gründen der Übersichtlichkeit in dieser Schnittzeichnung nicht dargestellt.

Die Druckeinrichtung (70) zur thermischen Verbindung des Leistungshalbleitermoduls (1) mit einem Kühlbauteil (2) und gleichzeitig zur elektrischen Kontaktierung der Lastanschlusselemente mit den Leiterbahnen des Substrats wird gebildet durch ein Druckelement (72) zum Druckaufbau auf den Stapel. Hierzu weist das Druckelement Druckfinger (74) nach dem Stand der Technik auf.

Fig. 2 zeigt in dreidimensionaler Darstellung ein Lastanschlusselement gemäß dem Stand der Technik. Dargestellt ist das Lastanschlusselement (44), mit einer Mehrzahl von Kontaktelementen (400), die von einem zugeordneten bandartigen Abschnitt (402) ausgehen. Die Kontakteinrichtung (404) bildet den externen Anschluss des Leistungshalbleitermoduls. Die Kontaktelemente sind einstückig durch Stanz-Biege-Verfahren ausgestaltet, wodurch die mittlere Materialfläche des bandartigen Abschnittes im Querschnitt zum definierten Stromfluss eine Mehrzahl von Unterbrechungen aufweist. Die dem Substrat zugewandten Endflächen (490) der Kontaktelemente dienen der Kontaktierung mit den zugeordneten Leiterbahnen (54).

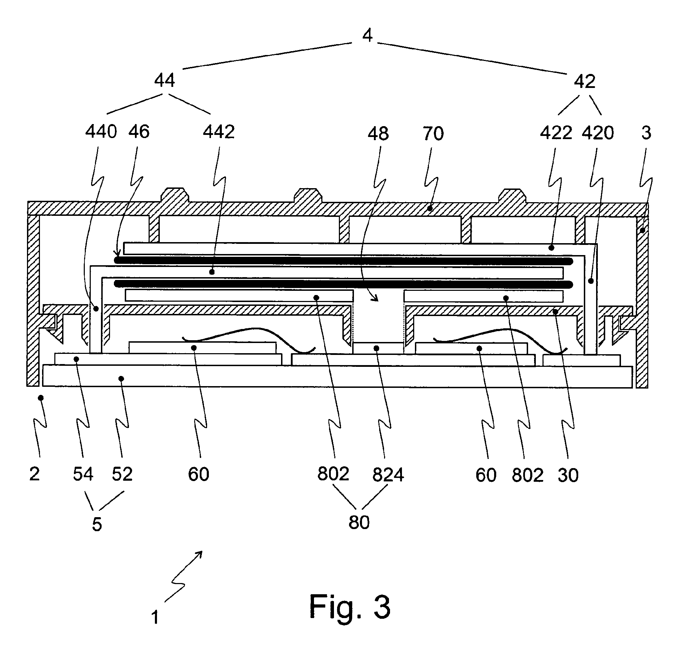

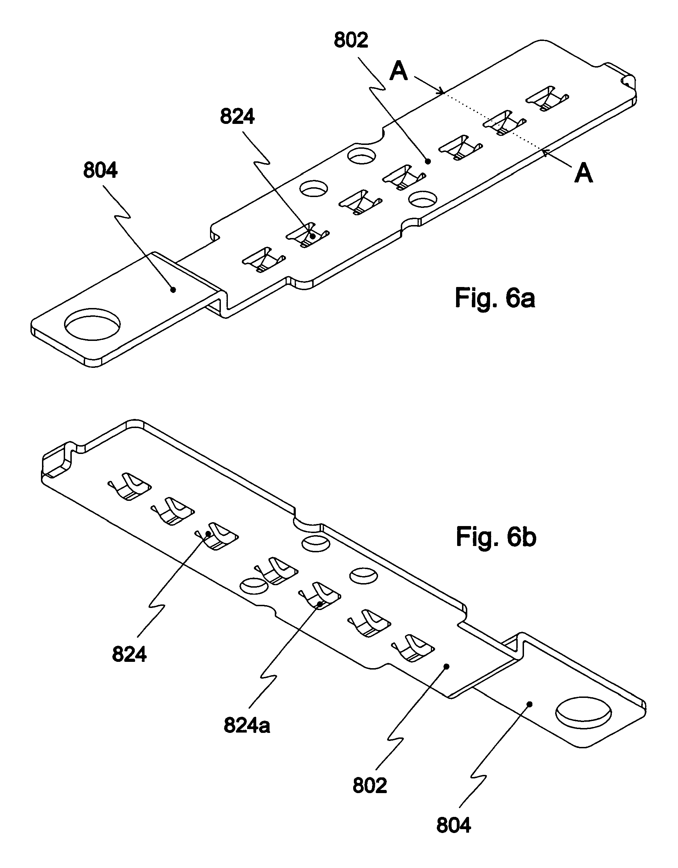

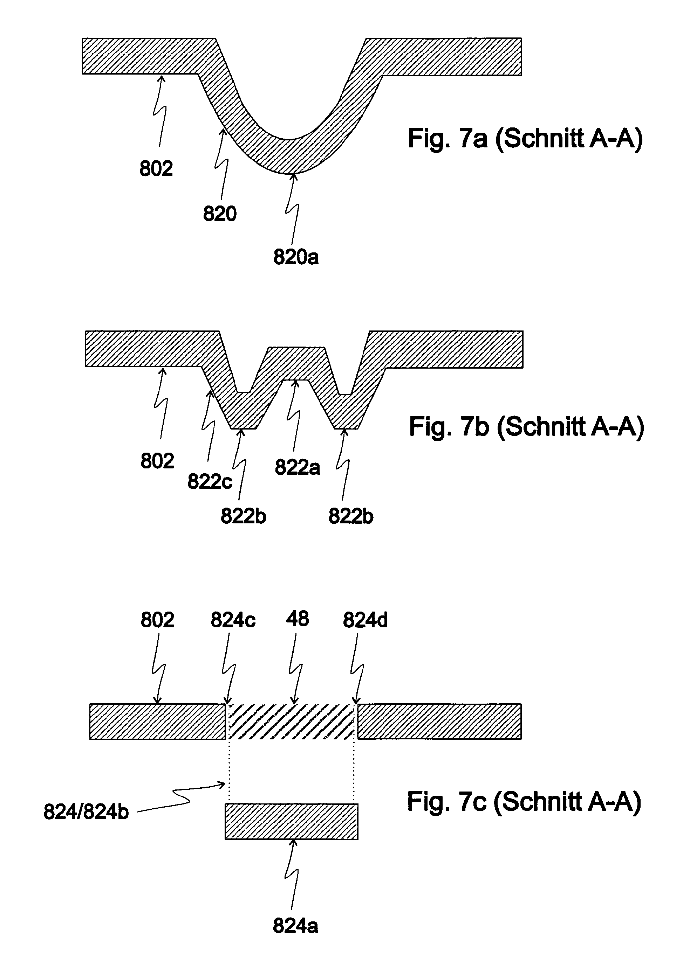

Fig. 3 zeigt im Querschnitt ein erfindungsgemäßes Leistungshalbleitermodul in Weiterbildung des Standes der Technik, wobei hier baugleiche Elemente zu Fig. 1 nicht extra beschrieben sind. Erfindungsgemäß sind hier die zweiten Kontaktelemente (824) als einstückig ausgebildete, freigestellte Kontaktnasen ausgebildet (siehe hierzu auch Fig. 6), wobei sich in dieser Ausgestaltung keine Unterbrechung der Materialfläche (48) des bandartigen Abschnitts (802) des Lastanschlusselements (80) ergibt (siehe hierzu auch Fig. 7). Weiterhin dargestellt ist eine ebenfalls einstückig aus dem Material des Lastanschlusselements ausgebildete Lasche (49), welche in der Verlängerung des bandartigen Abschnittes (802) eine Biegung in Richtung des Substrats aufweist und mit einer entsprechend zugeordneten Aussparung im Substrat (nicht dargestellt) zur Fixierung der Lage bezüglich der Rotation um die Längsachse des Lastanschlusselements dient.

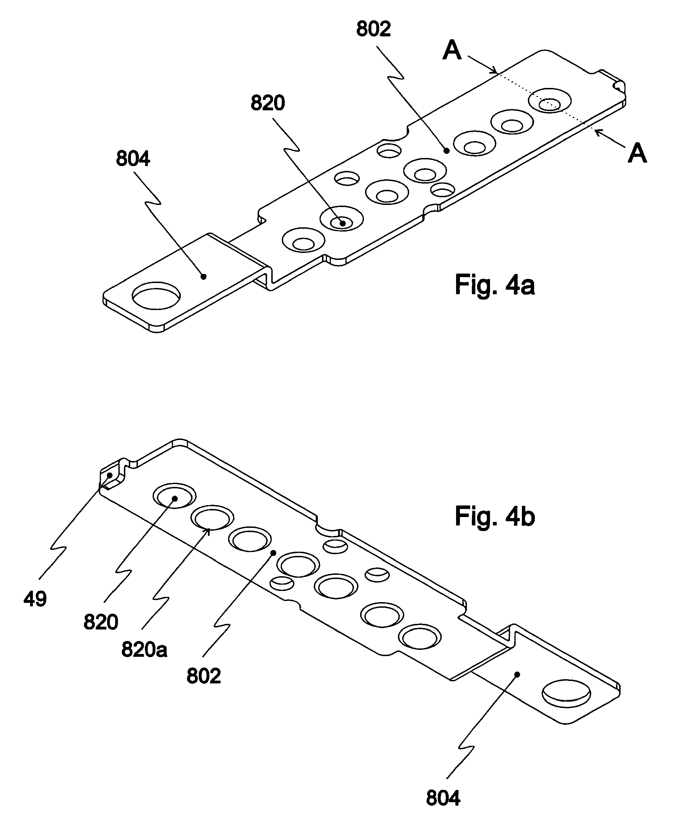

Fig. 4 zeigt in dreidimensionaler Ansicht eine erste Ausgestaltung eines Lastanschlusselements eines erfindungsgemäßen Leistungshalbleitermoduls in Auf (4a)- und Untersicht (4b). Hierbei sind die zweiten Kontaktelemente (820) als einstückig aus dem Material vorspringende Noppen ausgestaltet, welche durch die Beaufschlagung mit Druck mittels der Druckeinrichtung (70) mit ihren dem Substrat zugewandten Noppenkappen (820a) die elektrische Kontaktierung mit den Leiterbahnen (54) des Substrats (5) ermöglichen.

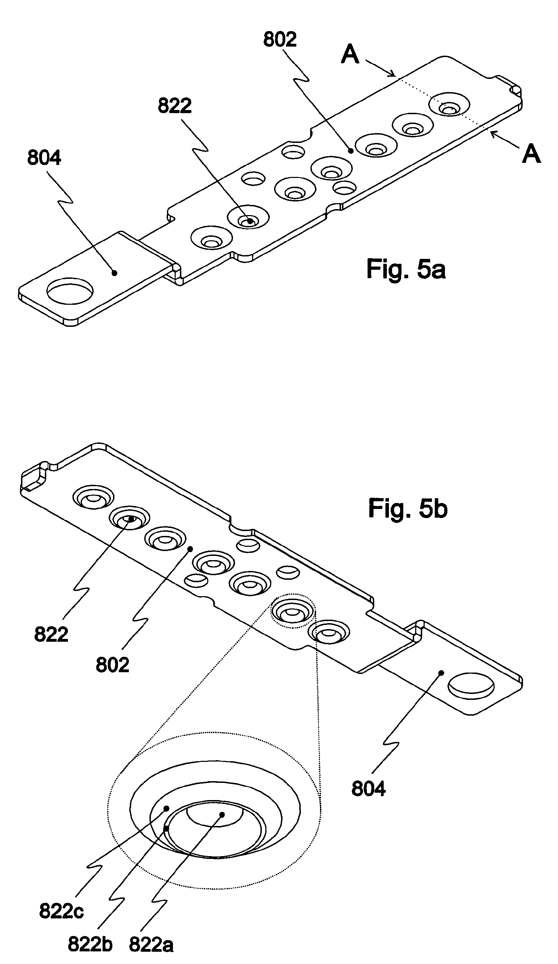

Fig. 5 zeigt in dreidimensionaler Ansicht eine zweite Ausgestaltung eines Lastanschlusselements eines erfindungsgemäßen Leistungshalbleitermoduls in Auf (5a)- und Untersicht (5b). Hierbei sind die zweiten Kontaktelemente (822) ebenfalls als einstückig aus dem Material vorspringende Noppen ausgestaltet, wobei hier bei jeder Noppe der Scheitelpunkt ihrer Noppenkappe diametral zur Richtung des Vorsprungs vertieft ist (822a). Auf diese Art weist jede Noppe nunmehr einen Kontaktring-Stirnflächenabschnitt (822b) und einen zylindrischen Mantelabschnitt (822c) auf, wobei der Kontaktring-Stirnflächenabschnitt in Verbindung mit der Druckeinrichtung (70) des Leistungshalbleitermoduls die sichere elektrische Kontaktierung mit den zugeordneten Leiterbahnen (54) ermöglicht.

Fig. 6 zeigt in dreidimensionaler Ansicht eine dritte Ausgestaltung eines Lastanschlusselements eines erfindungsgemäßen Leistungshalbleitermoduls in Auf (6a)- und Untersicht (6b). Hierbei sind die zweiten Kontaktelemente (824) einstückig und in Stromflussrichtung unterbrechungsfrei freigestellt und in Richtung des Substrats vertieft, sodass sich entsprechende Kontaktnasen ausbilden, welche im Flächenschnitt des bandartigen Abschnittes (802) eine gewölbte Überspannung einer Öffnung ohne Materialunterbrechung in Stromflussrichtung darstellen. Die dem Substrat zugewandten Kontaktflächenabschnitte (824a) dieser Kontaktnasen ermöglichen in Verbindung mit der Druckeinrichtung (70) des Leistungshalbleitermoduls die sichere elektrische Kontaktierung mit den zugeordneten Leiterbahnen (54). Weiterhin dargestellt

Fig. 7 zeigt in ihren Ausführungen 7a, 7b und 7c jeweils einen zweidimensionalen Schnitt durch ein Lastanschlusselement eines erfindungsgemäßes Leistungshalbleitermodul durch die Schnittebene A-A.
Fig. 7a zeigt den entsprechenden Schnitt durch Fig. 4a mit einem Kontaktelement (820) als einstückig aus dem Material vorspringender Noppe und ihrer Noppenkappe (820a), welche die elektrische Kontaktierung mit den zugeordneten Leiterbahnen ermöglicht.
Fig. 7b zeigt den entsprechenden Schnitt durch Fig. 5a mit einem Kontaktelement (822) als einstückig aus dem Material vorspringender Noppe mit vertiefter Noppenkappe (822a) und sich daraus ergebendem Kontaktring-Stirnflächenabschnitt (822b) und zylindrischem Mantelabschnitt (822c).
Fig. 7c zeigt den entsprechenden Schnitt durch Fig. 6a mit einem Kontaktelement (824) als einstückig aus dem Material freigestellte Kontaktnase, deren in Richtung des Substrats vertiefte gewölbte Überspannung (824b) an der dem Substrat zugewandten Seite eine Kontaktfläche (824a) ausbildet. Die notwendige Freistellung der Kontaktnasen aus dem Material des bandartigen Abschnitts (802) erfolgt hierbei lediglich durch schlitzartige Ausnehmungen (824c) in der definierten Längsrichtung des Stromflusses, sodass das Material des Kontaktelementes an sich in Längsrichtung des Stromflusses unterbrechungsfrei bleibt (48, als schematische Darstellung).

## Patentansprüche

1. Leistungshalbleitermodul (1) in Druckkontaktausführung zur Anordnung auf einem Kühlbauteil (2), mit mindestens einem Substrat (5), mindestens einem hierauf angeordneten Leistungshalbleiterbauelement (60), einem Gehäuse (3) und nach außen führenden Last- (80, 42, 44) und Steueranschlusselementen und mit einer Druckeinrichtung (70), wobei das Substrat (5) einen Grundkörper (52) aufweist und auf dessen erster dem Inneren des Leistungshalbleitermoduls zugewandten Hauptfläche Leiterbahnen (54) mit Lastpotential angeordnet sind
wobei mindestens ein Lastanschlusselement als Metallformkörper mit mindestens einem ersten Kontaktelement (804), einem bandartigen Abschnitt (802) und mit von diesem ausgehenden zweiten Kontaktelementen (820, 822, 824) ausgebildet sind, der bandartige Abschnitt parallel zur Substratoberfläche und von dieser beabstandet angeordnet sind und die zweiten Kontaktelemente von dem bandartigen Abschnitt zum Substrat (5) reichen und dieses schaltungsgerecht kontaktieren, und
wobei die zweiten Kontaktelemente (820, 822, 824) als materialeinstückig mit dem bandartigen Abschnitt ausgebildete Vorsprünge (820, 822) oder als ebenso materialeinstückige freigestellte Kontaktnasen (824) ausgebildet sind,
wobei schlitzartige Ausnehmungen zur Freistellung der Kontaktnasen in Stromrichtung oder unter einem Winkel von maximal 15° angeordnet sind, um einen im Wesentlichen unterbrechungsfreien Stromfluss zu gewährleisten.

2. Leistungshalbleitermodul (1) nach Anspruch 1
wobei die Vorsprünge (820, 822) eine noppenartige Form aufweisen.

3. Leistungshalbleitermodul (1) nach Anspruch 2,
wobei die noppenartige Form der Vorsprünge (822) in ihrem Scheitelpunkt eine Vertiefung (822a) aufweist, welche einen der Grundflächenform der Noppe entsprechenden Kontakt-Stirnflächenabschnitt (822b) und einen zylindrischen Mantelabschnitt (822c) ausbildet.

4. Leistungshalbleitermodul (1) nach Anspruch 1
wobei die Kontaktnasen (824) in Richtung des Substrates freigestellte gewölbte Überspannungen (824a) aufweisen.

5. Leistungshalbleitermodul (1) nach Anspruch 1,
wobei die bandartigen Abschnitte (802, 422, 442) der Lastanschlusselemente (80, 42, 44) einen Stapel bilden.

6. Leistungshalbleitermodul (1) nach Anspruch 5,
wobei die bandartigen Abschnitte (802, 422, 442) der einzelnen Lastanschlusselemente (80, 42, 44) jeweils eine isolierende Zwischenlage (46) aufweisen.
